(19) Europäisches Patentamt
European Patent Office
Office européen des brevets

(11) **EP 0 674 342 B1**

(12) **EUROPEAN PATENT SPECIFICATION**

(45) Date of publication and mention
of the grant of the patent:
**05.09.2001 Bulletin 2001/36**

(51) Int Cl.[7]: **H01L 21/027**

(86) International application number:
**PCT/JP94/01705**

(21) Application number: **94929643.8**

(22) Date of filing: **12.10.1994**

(87) International publication number:
**WO 95/10849 (20.04.1995 Gazette 1995/17)**

(54) **METHOD FOR EVALUATING FOCAL POINT**

VERFAHREN ZUR BESTIMMUNG DES BRENNPUNKTS

PROCEDE D'EVALUATION DU FOYER

(84) Designated Contracting States:
**DE FR NL**

(30) Priority: **13.10.1993 JP 25600393**

(43) Date of publication of application:
**27.09.1995 Bulletin 1995/39**

(73) Proprietor: **Oki Electric Industry Company,
Limited
Tokyo 105 (JP)**

(72) Inventor: **WATANABE, Akira,
Oki Electric Industry Co.,Ltd.
Tokyo 105 (JP)**

(74) Representative: **Betten & Resch
Postfach 10 02 51
80076 München (DE)**

(56) References cited:
**EP-A- 0 111 635       EP-A- 0 338 200
JP-A- 49 079 472       JP-A- 58 077 231
JP-A- 63 019 830**

• **MOTOROLA TECHNICAL DEVELOPMENTS, vol.
16, August 1992 SCHAUMBURG, ILLINOIS US,
pages 121-124, XP 000310385 S. MALHOTRA ET
AL. 'METHOD FOR DETERMINING STEPPER
FOCUS AND OFFSETS'**

## Description

Technical Field

This invention relates to a pattern for focus estimation and, more particularly, to a pattern for focus estimation to come in focus at an exposure process for a semiconductor device manufacturing process. Moreover, it relates to a method for estimating focus in use of the pattern for focus estimation.

Background Technology

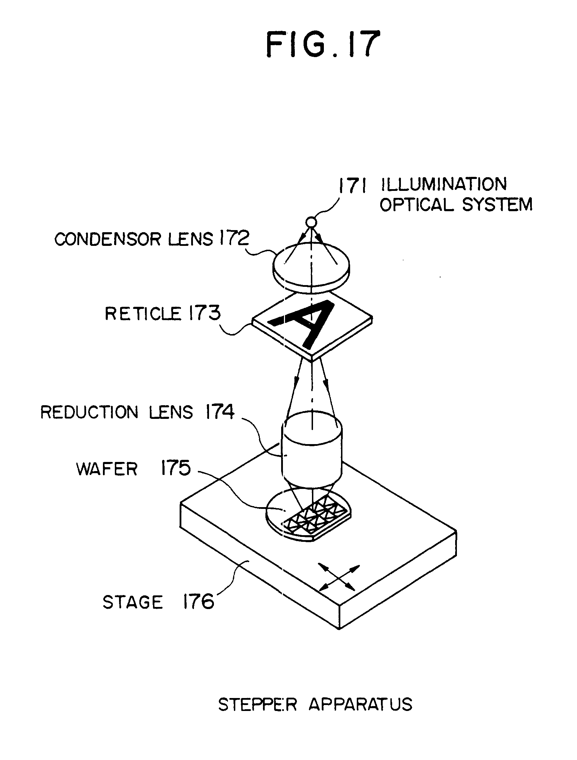

Reduction projection exposure has conventionally been used for high resolution pattern formations, as described in "VLSI Technology Guide [Nyumon]" (Heibonshia), p. 143-144. With this method, any defect of a mask does not occur during the exposure process because the mask and the wafer do not contact with each other, so that a high yield can be ensured. Apparatuses used for the reduction projection exposure method are referred to as steppers. Hereinafter, referring to Fig. 17, this reduction projection exposure method is described. Light from a mercury lamp 171 as a light source passes through a filter and becomes light of a sole frequency. The light reaches a reticle 173, an original of a pattern, after passing through a condenser lens 172. The light passed through transparent portions of the reticle comes into focus after passing through a reduction lens 174. Generally, the light is automatically focalized according to respective exposure conditions by means of a sensor (not shown) provided near the light source for detecting the position of a wafer.

However, practically, the wafer position set by the sensor and the focal position at which the optical system brings the light into focus are not always matched, and therefore, generally, the deviations are previously measured and required to be corrected.

From the EP-A-0 338 200 a method is known of determining the optimum position of a wafer with respect to a focal point of an apparatus for manufacturing the semiconductor device, having a radiation source, means for supporting a semiconductor wafer, and a reticle interposed between the radiation source and the wafer, comprising the steps of: preparing a pattern with a plurality of objects having a size which is equal or larger than the resolution limit and projecting and transferring the reticle patterns onto the wafer a plurality of times at different distances of the wafer from the reticle. The determination or measurement of the best focus is carried out by counting the number of patterns objects resolved on the wafer and evaluation of their respective midpoint representing the best focus.

Due to this counting the prior art method is unsatisfying with regard to its cost efficiency.

It is thus an object of the present invention to overcome the above briefly discussed deficiency of the prior art.

This is obtained by the combination of features according to claim 1. The method according to claim 1 differs from the above discussed prior art (EP-A-0 338 200) in that each of the elements of the reticle patterns being separated from adjacent elements by a distance which is not greater than the resolution limit of the apparatus, measuring the spacing between the first and second end portions of the transferred reticle patterns, selecting one of the measured spacings, namely the extremal value, and setting the wafer at the position corresponding to the chosen spacing.

Motorola Technical Developments, vol.16 (August 1992), Schaumburg, Illinois, US, pages 121 to 124; S. Malhotra et a1. "Method for determining stepper focus and offsets" discloses a method using a snake patterned reticle, a tightly pitched large pattern, which provides a naked eye inspection.

EP-A-0 111 635 describes a method to determine the focus of an optical arrangement in which the distance of a pattern and a surface onto which the pattern is projected is varied and the corresponding size of a portion of the projected pattern is measured. From the extremal value of the pattern size the optimal focus is determined.

Brief Description of Drawings

Fig. 1 is a diagram illustrating a first reticle pattern for focus estimation of the invention;
Fig. 2 is a diagram illustrating transferred patterns of the reticle pattern in Fig. 1;
Fig. 3 is a diagram showing a relation between wafer position and transferred pattern size in an X-axial direction;
Fig. 4 is a diagram schematically showing a relation between wafer position and transferred pattern size in the X-axial direction;
Fig. 5 is a diagram illustrating a second reticle pattern for focus estimation of the invention;
Fig. 6 is a diagram illustrating transferred patterns of the reticle pattern in Fig. 5;
Fig. 7 is a diagram illustrating a third reticle pattern for focus estimation of the invention;
Fig. 8 is a diagram showing a relation between size of the transferred pattern in an X-axial direction and wafer position in the case in use of the reticle pattern in Fig. 7 of a1 = 0.2, a2 = 2.0, and a3 = 0.3 $\mu$m;

Fig. 9 is a diagram showing a relation between size of the transferred pattern in an X-axial direction and wafer position in the case in use of the reticle pattern in Fig. 7 of a1 = 0.2, a2 = 3.0, and a3 = 0.3 µm;

Fig. 10 is a diagram showing a relation between size of the transferred pattern in an X-axial direction and wafer position in the case in use of the reticle pattern in Fig. 7 of a1 = 0.2, a2 = 5.0, and a3 = 0.3 µm;

Fig. 11 is a diagram showing a relation between size of the transferred pattern in an X-axial direction and wafer position in the case in use of the reticle pattern in Fig. 7 of a1 = 0.1, a2 = 5.0, and a3 = 0.2 µm;

Fig. 12 is a diagram showing a relation between size of the transferred pattern in an X-axial direction and wafer position in the case in use of the reticle pattern in Fig. 7 of a1 = 0.2, a2 = 5.0, and a3 = 0.2 µm;

Fig. 13 is a diagram showing a relation between size of the transferred pattern in an X-axial direction and wafer position in the case in use of the reticle pattern in Fig. 7 of a1 = 0.1, a2 = 5.0, and a3 = 0.3 µm;

Fig. 14 is a diagram showing comparative data;

Fig. 15 is a diagram illustrating a fourth reticle pattern for focus estimation of the invention;

Fig. 16 is a diagram illustrating a fifth reticle pattern for focus estimation of the invention; and

Fig. 17 is a diagram illustrating a stepper apparatus.

Best Mode for Carrying Out the Invention

[First Embodiment]

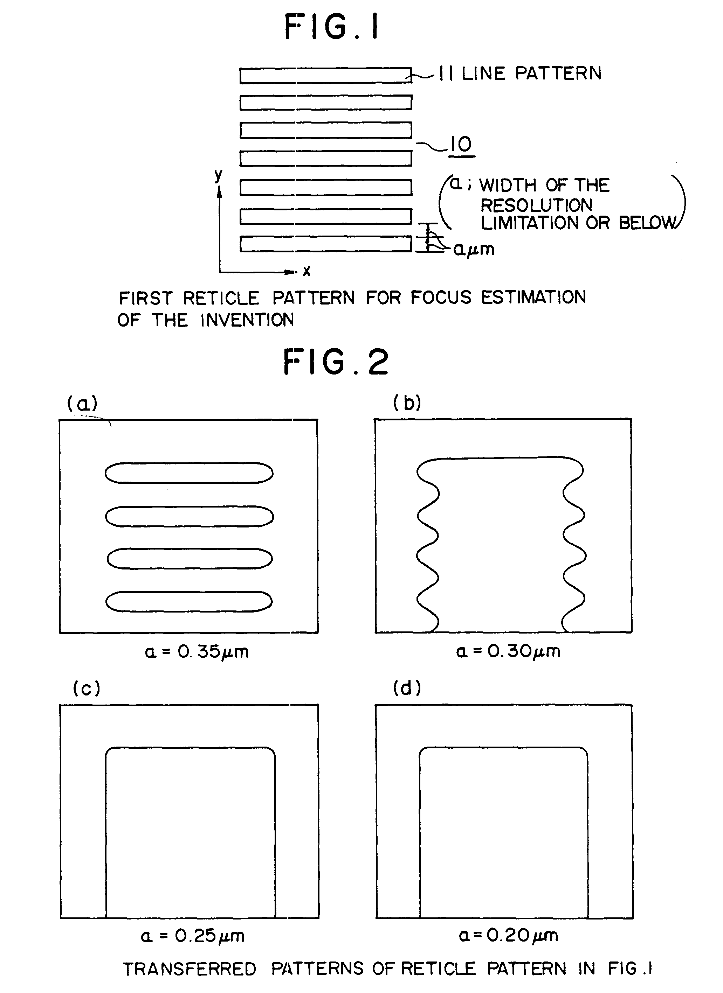

Fig. 1 is a diagram illustrating a first reticle pattern for focus estimation of the invention. In Fig. 1, line patterns 11 extending crosswise with width $\alpha$ µm are arranged with intervals of $\alpha$ µm lengthwise. The pattern width $\alpha$ is a line width less than the resolution limitation of a stepper performing exposure. Here, since N.A. (Numerical Aperture of Lens) = 0.5, i-line (365 nm) is used, the resolution limitation R of the stepper is, theoretically:

$$R = k\frac{\lambda}{N.A.}$$

$\lambda$: Exposure Frequency
N.A.: Numerical Aperture of Lens
k = 0.5 (constant)

therefore,

$$R = 0.5 \text{ x } \frac{0.365}{0.5} = 0.365$$

Accordingly, the pattern width and pattern interval $\alpha$ can be equal to or less than 0.365 µm, theoretically.

Next, transferred patterns when the reticle pattern for focus estimation in Fig. 1 is transferred onto a wafer are described.

Fig. 2(a) is a transferred pattern in the case that $\alpha$ value of the pattern width and pattern interval of the reticle pattern in Fig. 1 is 0.35 µm. Although the end of the line pattern is rounded, respective line patterns are separated. Fig. 2(b) is a transferred pattern in the case that $\alpha$ value of the pattern width and pattern interval of the reticle pattern in Fig. 1 is 0.30 µm. The respective line patterns are not separated; the ends of the transferred patterns are corrugated. Fig. 2(c) is a transferred pattern in the case that $\alpha$ value of the pattern width and pattern interval of the reticle pattern in Fig. 1 is 0.25 µm. The respective patterns are not separated; the transferred pattern is formed in a large square. Fig. 2(d) is a transferred pattern in the case that $\alpha$ value of the pattern width and pattern interval of the reticle pattern in Fig. 1 is 0.20 µm. The respective patterns are not separated; the transferred pattern is formed in a large square.

The $\alpha$ value above is a numerical value when the pattern is transferred onto a wafer, and takes a value five times of it when the pattern is on the reticle (in the case of the 1/5 reduction). The exposure period was 160 msec.

Thus, the patterns are not precisely separated or do not make distinctive resolution when the patterns have the pattern width and pattern interval equal to or less than the resolution limitation; when the pattern width and pattern interval are equal to or less than 0.25 µm, the pattern is formed in a large square in appearance.

Next, there describes a method for estimating focus in use of the reticle pattern shown in Fig. 1.

First, the reticle pattern in Fig. 1 is prepared. Here, the reticle pattern whose pattern width and pattern interval are 0.25 µm (Fig. 2(c)) is employed. As shown in Fig. 2(c), when this reticle pattern is employed, the form of the transferred pattern becomes a large square in appearance, so that the size is easily measured. This reticle pattern is transferred (exposed and developed) onto a wafer in varying the wafer position to be brought to plural subdivided areas of the wafer on which photoresist has previously coated. Here, the exposure amount was a constant; the exposure time was set at 160 msec. The wafer position set up by the sensor is made as the reference (0), and the wafer position is varied from the reference by 0.1, 0.2, and 0.3 μm upward (+) and by 0.1, 0.2, and 0.3 μm downward (-). Here the wafer position means the wafer position of vertical direction on the stage of Fig. 17, which is explained in paragraphs in Background Technology. Next, the size in the X axial direction of the transferred patterns transferred onto the wafer is measured by an optical size measuring equipment.

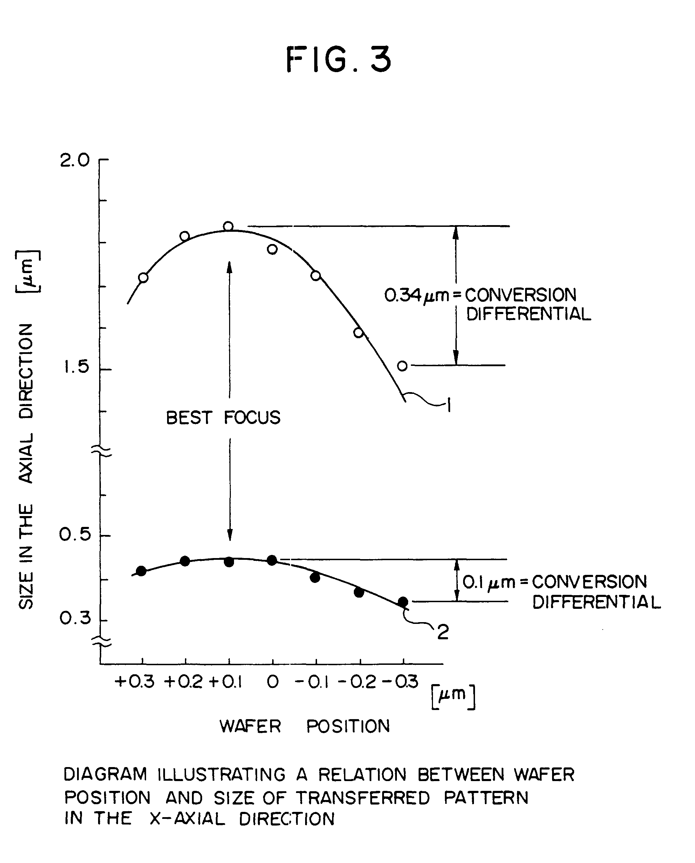

Graph 1 in Fig. 3 shows a relation between size in the X axial direction and wafer position in this case. The maximum value of Graph 1 becomes the wafer position (the best focus position) at which the pattern comes into focus. That is, in this case, the position at which the pattern comes into focus has shifted 0.1 μm from the set position by the sensor.

Thus, under a constant exposure condition, the best focus position can be judged from the correlation diagram of the wafer position and the size of the transferred pattern in the X axial direction, and therefore, the pattern can be formed more accurately by correcting the set position by the sensor in consideration of the deviations between the best focus position and the set position by the sensor.

Graph 2 is, here, data for describing the effects of the invention and is a measurement result of size of the transferred pattern in the X axial direction when it is transferred using a reticle pattern with its pattern width and pattern interval of 0.5 μm. Where the pattern width and pattern interval are 0.5 μm, the respective line patterns are separated and made distinctively, and the whole shape does not constitute a square. That was measured by an SEM type size measuring equipment. The reason that the SEM type size measuring equipment was used is that very fine line width as of 0.5 μm cannot be measured by an optical size measuring equipment. Its details are specifically described in a third embodiment.

In Graph 1, the wafer position at which the pattern comes into focus (the best focus position) is at +0.1 μm, and the deviation (conversion differential) between the size in the X axial direction where the wafer position is at -0.3 μm and the size in the X axial direction at a point of inflection (where the wafer position is at +0.1 μm) is about 0.34 μm.

In contrast, where a reticle pattern with its pattern width and pattern interval of 0.5 μm is employed, the conversion differential is about 0.1 μm.

Accordingly, it turns out that the method for estimating focus of the invention has sensitivity three times or more.

Thus, according to the method for estimating focus in use of the first reticle pattern for focus estimation, the conversion amount of the size of the transferred pattern against the changes of the wafer position can be made larger, so that the best focus position can be judged easily. Consequently, from the judgment of the best focus position, the pattern can be accurately formed by finely adjusting the wafer position.

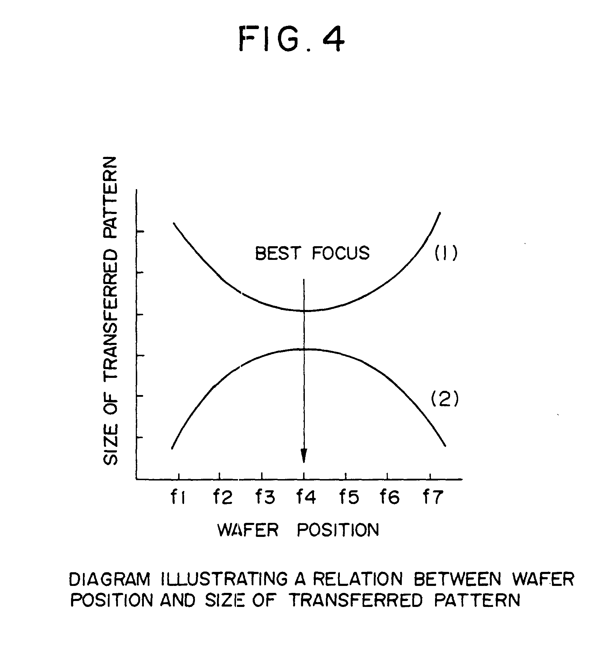

In Fig. 3, because in both of Graphs, 1, 2 the widths of the transferred patterns shift toward size reduction, convex shaped curves are shown . However, if an exposure amount becomes large or an exposing period becomes longer, the widths of the transferred patterns would shift toward size enlargement, so that concave shaped curves would be shown. In Fig. 4, Graph (2) in a convex shape and Graph (1) in a concave shape are schematically shown. In the case of Graph (1), the minimum value of Graph indicates the best focus position.

That is, where many points of inflection in the graph or a large exposure amount exists or where an exposure period is longer, the maximum value indicates the wafer position (the best focus position) at which the pattern comes into focus; where they are few, the minimum value indicates so.

[Second Embodiment]

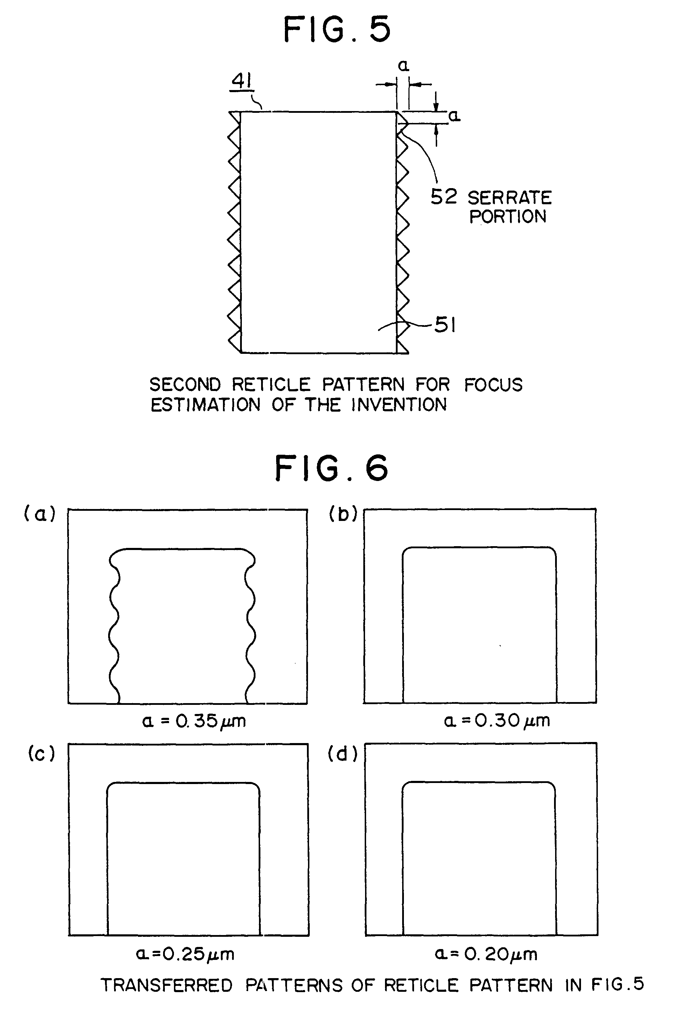

Fig. 5 shows a second reticle pattern 50 for focus estimation of the invention, and plural triangular serrate portions 52 are formed around a square pattern 51. The shape of the square pattern 51 is changeable when the change is proper. The triangular serrate portion 52 is a right angled isosceles triangle having base 2α μm and height α μm.

In Figs. 6(a), 6(b), 6(c) and 6(d), transferred patterns when the reticle pattern for focus estimation in Fig. 5 is transferred onto a wafer, are shown. Fig. 6(a) is a transferred pattern where the α value in Fig. 5 is 0.35 μm. The end of the transferred pattern is serrate. Fig. 6(b) is a transferred pattern where the α value in Fig. 5 is 0.30 μm. The transferred pattern is almost square. Fig. 6(c) is a transferred pattern where the α value in Fig. 5 is 0.25 μm. The transferred pattern is almost square. Fig. 6(d) is a transferred pattern where the α value in Fig. 5 is 0.20 μm. The transferred pattern is almost square. Here, the α value is a numerical value when the pattern is transferred onto a wafer, and takes a value five times of it on the reticle (in the case of the 1/5 reduction). The exposure period was set to 160 msec.

Thus, with the pattern width and pattern interval equal to or less than the resolution limitation, the pattern is not made accurately as distinctive; with the pattern width and pattern interval α of 0.30 μm or below, the pattern is formed in a square approximately in appearance.

Accordingly, for example, if the reticle pattern in Fig. 5 in which α = 0.30 μm is transferred in varying the wafer position in a manner as well as that in the first embodiment and then the size of the transferred pattern in the X axial direction is measured, a graph, similar to Graph 1 in Fig. 3, in which the conversion amount of the size of the transferred pattern against the changes of the wafer position is large would be obtained.

Thus, according to the method for estimating focus in use of the second reticle pattern for focus estimation of the invention, the conversion amount of the size of the transferred pattern against the changes of the wafer position can be larger, the best focus position can be easily judged. Accordingly, from the judgment of the best focus position, the pattern can be accurately formed by finely adjusting the wafer position.

[Third Embodiment]

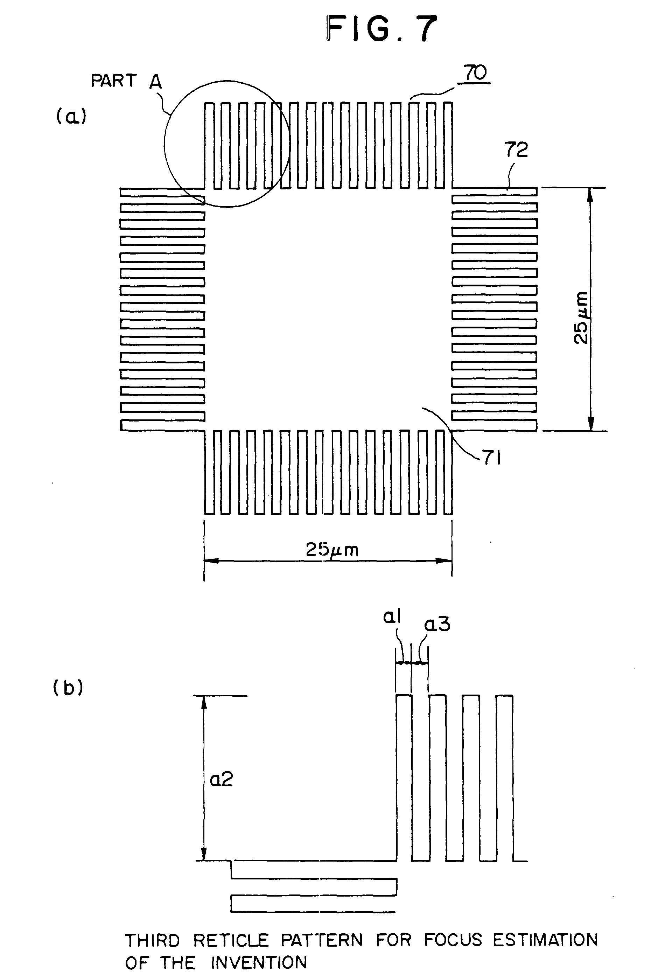

Fig. 7(a) is a third reticle pattern for focus estimation of the invention, and plural rectangular comb tooth portions 72 are formed around a first square pattern portion 71 of 25 μm square. The shape of the first square pattern portion 71 is changeable when the change is proper, and can be 10 or 40 μm square. It can be rectangular. Fig. 7(b) is an enlarged view of the upper left part (part A) of Fig. 7(a). As shown in Fig. 7(b), the rectangular comb tooth portion 72 is constituted of a rectangular with its width a1 and length a2 arranged at every distance a3. A method for estimating focus in use of the reticle pattern shown in Figs. 7(a), 7(b) is described as follows.

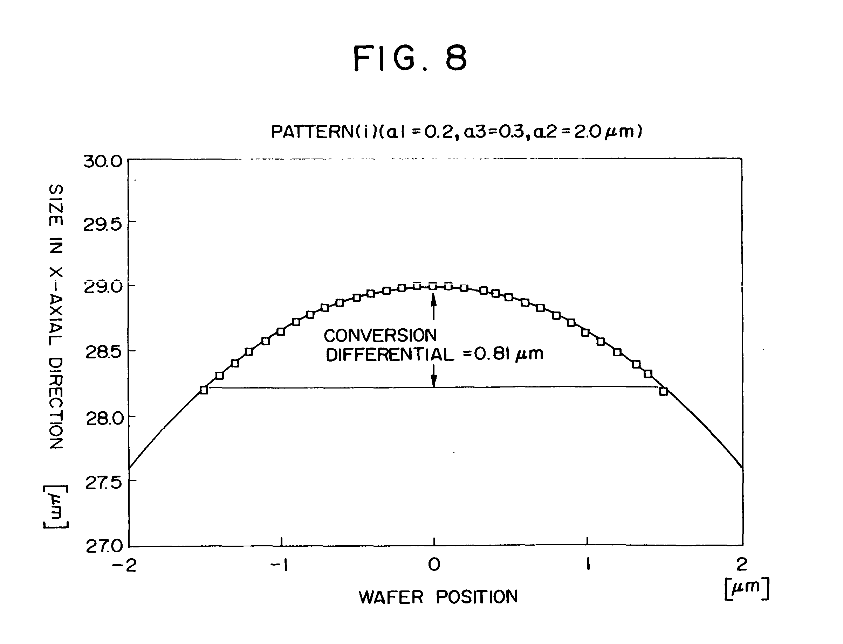

(i) There describes a method for estimating focus in use of the reticle pattern in Fig. 7(a) in which a1 = 0.2 μm, a2 = 2.0 μm, and a3 = 0.3 μm. First, the reticle pattern in Fig. 7(a) in which a1 = 0.2 μm, a2 = 2.0 μm, and a3 = 0.3 μm is prepared. Next, the pattern is transferred (exposed and developed) onto a wafer in varying the wafer position to be brought to plural subdivided areas of the wafer on which photoresist has previously coated. Here, the exposure amount and the exposure time were set to a constant, respectively. The wafer position was varied from +1.5 μm and -1.5 μm with the wafer position set up by the sensor as the reference (0). Next, the size in the X axial direction of the transferred patterns transferred onto the wafer is measured by an optical size measuring equipment. The optical size measuring equipment, here, has the advantages that it is cheaper than the SEM type measuring equipment described in the first embodiment, that it is for general purpose, and that it can measure in a short time and full automatically, but has a lower resolution power. That is, the equipment cannot measure any very fine pattern width around 0.5 μm as shown in the first embodiment. The relation between size of the transferred pattern in the X axial direction and wafer position in this case is shown in Fig. 8. In this case, the wafer position at which the pattern comes into focus (the best focus position) is at 0 μm, and the deviation (the conversion differential) between the size in the X axial direction when the wafer position is at 1.5 μm and the maximum value (in this case, the size in the X axial direction when the wafer position is at 0 μm = 29.0 ) is about 0.81 μm.

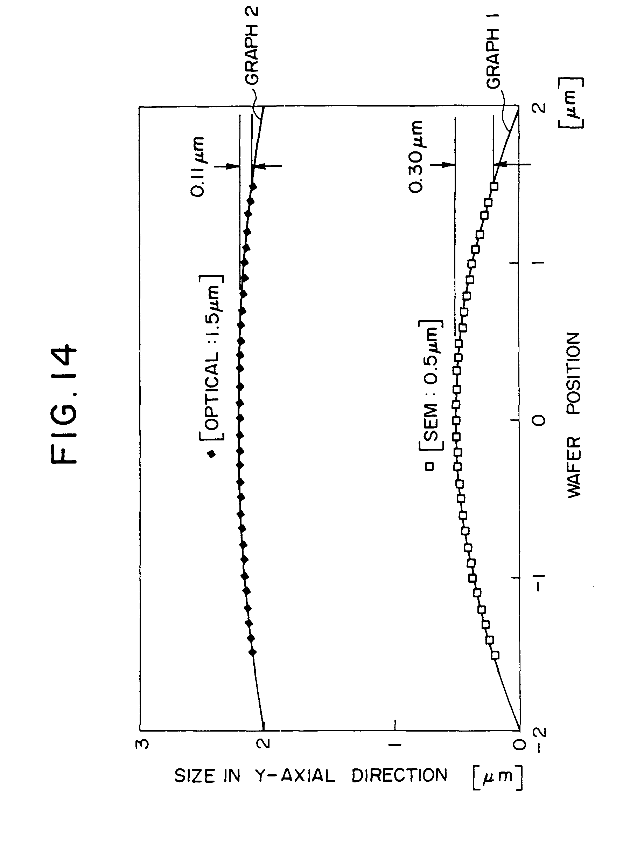

Fig. 14 shows comparative data. Graph 1 in Fig. 14 is a diagram showing a result in the case that size in a Y axial direction of the transferred pattern, to which a reticle pattern with its pattern width and pattern interval of 0.5 μm is transferred (exposed and developed) in varying its wafer position, is measured by an SEM type size measuring equipment. In this case, the deviation (the conversion differential) between the size in the Y axial direction when the wafer position is at -1.5 μm and the maximum value (in this case, the size in the X axial direction when the wafer position is at 0 μm = 29.0 ) is about 0.30 μm. Here, the reason that the conversion differential (0.30 μm) in this case is larger than that in the case of Graph 2 in Fig. 3 (the conversion differential = 0.1 μm) is that the wafer position is made to greatly change (from +1.5 μm to -1.5 μm). Thus, where a1, a2, and a3 of the reticle pattern in Fig. 7(a) are set to 0.2 μm, 2.0 μm, and 0.3 μm, respectively, the conversion differential about 2.7 times of that in the case that the line pattern with its pattern width and pattern interval of 0.5 μm is employed (the conversion differential = about 0.30 μm) is obtained. This pattern allows the pattern size to be measured easily and in a short time because it is measurable by the optical size measuring equipment.

For reference, a measurement result of the pattern size of the line pattern by the optical size measuring equipment is shown in Graph 2 in Fig. 14. The optical size measuring equipment cannot measure the pattern size of the transferred pattern unless the line pattern with its pattern width and pattern interval of about 1.5 μm is employed, because it has a low resolution power. In this case, as shown by Graph 2, the conversion differential is about 0.11 μm, which is 1/3 of that in the case of Graph 1. Accordingly, where measurement is conducted by the optical size measuring equipment, sensitivity eight times of that in the case that the line pattern with its pattern width and pattern interval of about 1.5 μm is employed is obtained if a reticle pattern around which comb tooth portions equal to or less than the resolution limitation are formed as shown in Fig. 7 is employed.

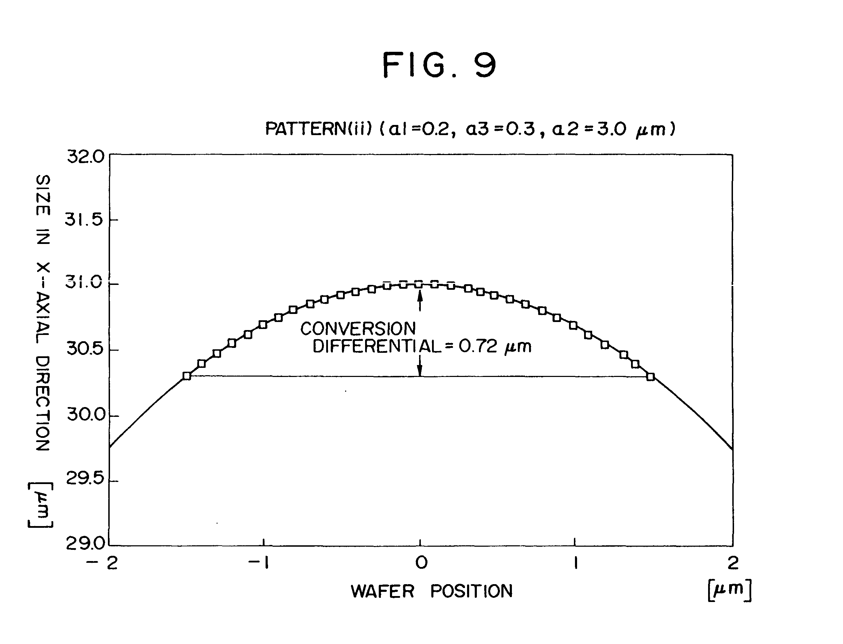

(ii) There describes a case transferred in a manner as well as (i) using a reticle pattern in Fig. 7(a) of a1 = 0.2 μm, a2 = 3.0 μm, and a3 = 0.3 μm. The relation between size of the transferred pattern in the X axial direction and wafer position in this case was shown in Fig. 9. In this case, the wafer position at which the pattern comes into focus (the best focus position) is at 0 μm, and the deviation (the conversion differential) between the size in the X axial direction when the wafer position is at -1.5 μm and the maximum value (in this case, the size in the X axial direction when the wafer position is at 0 μm = 31.0 ) is about 0.72 μm.

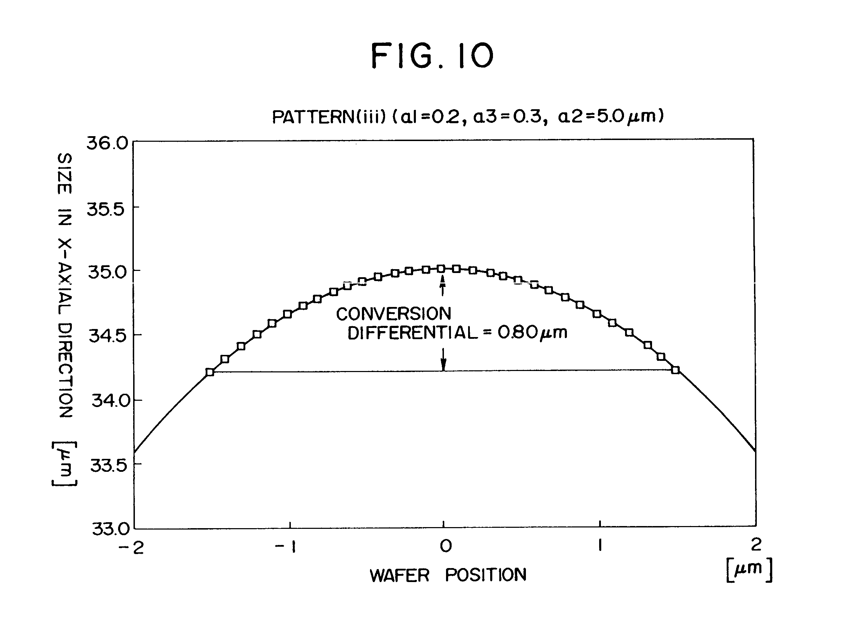

(iii) There describes a case transferred in a manner as well as (i) using a reticle pattern in Fig. 7(a) of a1 = 0.2 μm, a2 = 5.0 μm, and a3 = 0.3 μm. The relation between size of the transferred pattern in the X axial direction and wafer position in this case was shown in Fig. 10. In this case, the wafer position at which the pattern comes into focus (the best focus position) is at 0 µm, and the deviation (the conversion differential) between the size in the X axial direction when the wafer position is at -1.5 µm and the maximum value (in this case, the size in the X axial direction when the wafer position is at 0 µm = 35.0) is about 0.80 µm.

As shown in (i), (ii), and (iii), if a1 and a3 of the line pattern in Fig. 7(a) are 0.2 µm and 0.3 µm, respectively, the conversion differential of 0.7 to 0.8 µm is obtained notwithstanding the length a2. This is 2.4 to 2.8 times of the conversion differential (about 0.30 µm) in the case that the line pattern with its pattern width and pattern interval of about 0.5 µm is employed and measured by the SEM type size measuring equipment. Further, this is about 7 to 8 times of the conversion differential (about 0.11 µm) in the case that the line pattern with its pattern width and pattern interval of about 1.5 µm is employed and measured by the optical size measuring equipment.

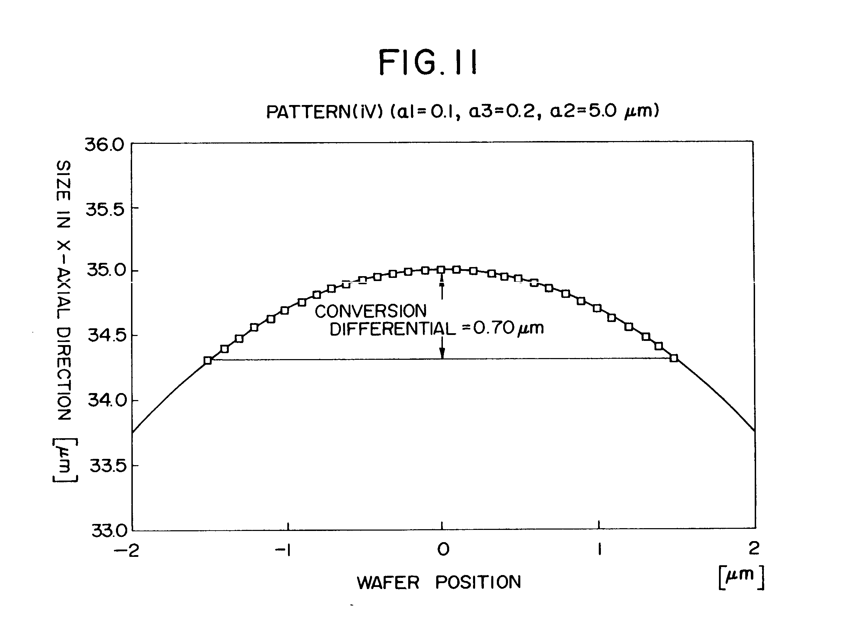

(iv) Furthermore, there describes a case transferred in a manner as well as (i) using a reticle pattern in Fig. 7(a) of a1 = 0.1 µm, a2 = 5.0 µm, and a3 = 0.2 µm. The relation between size of the transferred pattern in the X axial direction and wafer position in this case was shown in Fig. 11. In this case, the wafer position at which the pattern comes into focus (the best focus position) is at 0 µm, and the deviation (the conversion differential) between the size in the X axial direction when the wafer position is at -1.5 µm and the maximum value (in this case, the size in the X axial direction when the wafer position is at 0 µm = 35.0 ) is about 0.70 µm. This numerical value is also a value seven times of the conversion differential (about 0.1 µm) in the case that the line pattern with its pattern width and pattern interval of about 0.5 µm is employed.

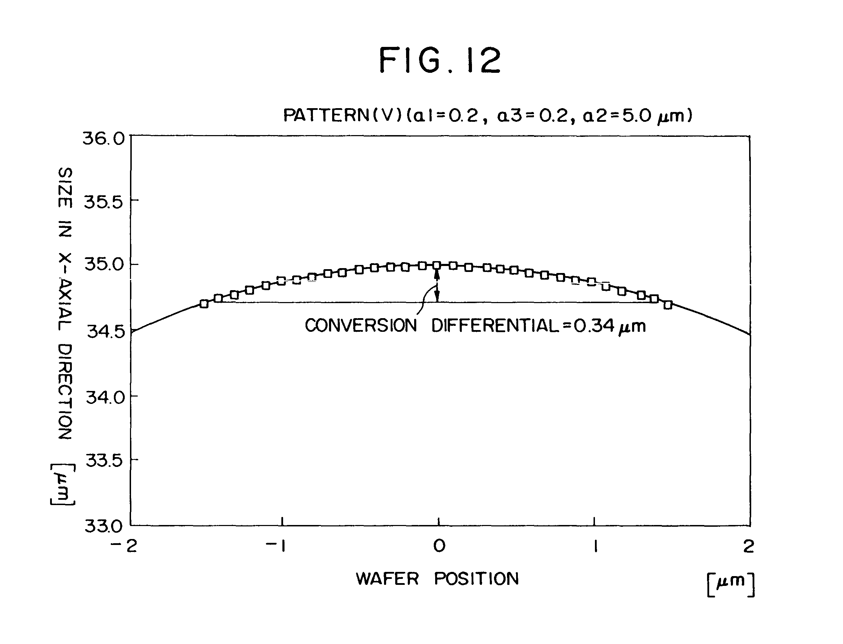

(v) There describes a case transferred in a manner as well as (i) using a reticle pattern in Fig. 7(a) of a1 = 0.2 µm, a2 = 5.0 µm, and a3 = 0.2 µm. The relation between size of the transferred pattern in the X axial direction and wafer position in this case was shown in Fig. 12. In this case, the wafer position at which the pattern comes into focus (the best focus position) is at 0 µm, and the deviation (the conversion differential) between the size in the X axial direction when the wafer position is at -1.5 µm and the maximum value (in this case, the size in the X axial direction when the wafer position is at 0 µm = 35.0 ) is about 0.34 µm. This numerical value is 1.13 times of the conversion differential (about 0.30 µm) in the case that the line pattern with its pattern width and pattern interval of about 0.5 µm is employed and measured by the SEM type size measuring equipment, and is about 3 times of the conversion differential (about 0.11 µm) in the case that the line pattern with its pattern width and pattern interval of about 1.5 µm is employed and measured by the optical size measuring equipment, but is about half of sensitivity of the results of (i) to (iv).

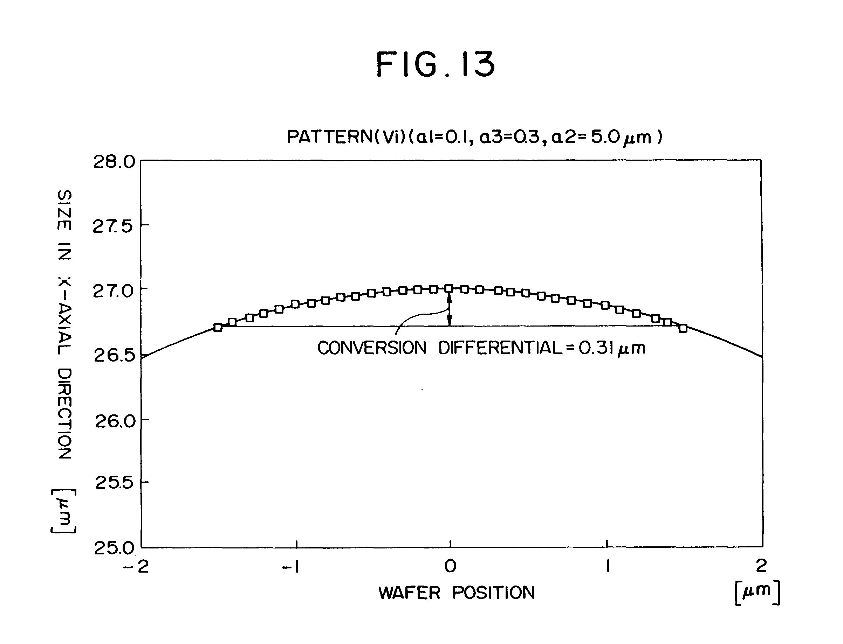

(iv) There describes a case transferred in a manner as well as (i) using a reticle pattern in Fig. 7(a) of a1 = 0.1 µm, a2 = 5.0 µm, and a3 = 0.3 µm. The relation between size of the transferred pattern in the X axial direction and wafer position in this case was shown in Fig. 13. In this case, the wafer position at which the pattern comes into focus (the best focus position) is at 0 µm, and the deviation (the conversion differential) between the size in the X axial direction when the wafer position is at -1.5 µm and the maximum value (in this case, the size in the X axial direction when the wafer position is at 0 µm = 27.0 ) is about 0.31 µm. This numerical value is 1.03 times of the conversion differential (about 0.30 µm) in the case that the line pattern with its pattern width and pattern interval of about 0.5 µm is employed and measured by the SEM type size measuring equipment, and is about 3 times of the conversion differential (about 0.11 µm) in the case that the line pattern with its pattern width and pattern interval of about 1.5 µm is employed and measured by the optical size measuring equipment, but is about half of sensitivity of the results of (i) to (iv).

Table 1 shows data of the conversion differentials of (i) to (vi) above.

Table 1

| | | | | | | | | [Unit: µm] |
|---|---|---|---|---|---|---|---|---|
| Measuring Method | SEM | Optical | Optical | Optical | Optical | Optical | Optical | Optical |
| Pattern | Line Pattern | Line Pattern | (i) | (ii) | (iii) | (iv) | (v) | (vi) |
| Pattern Shape | Pattern Width & Interval = 0.5 | Pattern Width & Interval = 0.5 | a1 = 0.2 a3 = 0.3 a2 = 2.0 | a1 = 0.2 a3 = 0.3 a2 = 3.0 | a1 = 0.2 a3 = 0.3 a2 = 5.0 | a1 = 0.1 a3 = 0.2 a2 = 5.0 | a1 = 0.2 a3 = 0.2 a2 = 5.0 | a1 = 0.1 a3 = 0.3 a2 = 5.0 |
| Conversion Differential | 0.30 | 0.11 | 0.81 | 0.72 | 0.80 | 0.70 | 0.34 | 0.31 |
| Sensitivity Ratio | 1.00 | 0.36 | 2.70 | 2.40 | 2.67 | 2.33 | 1.13 | 1.03 |

Thus, when the reticle pattern for focus estimation in Fig. 7(a) is used, the conversion amount of the pattern size against the changes of the wafer position can be made larger. Accordingly, the best focus position is judged easily, and patterns can be formed accurately by finely adjusting the wafer position from the judgment of the best focus position.

[Fourth Embodiment]

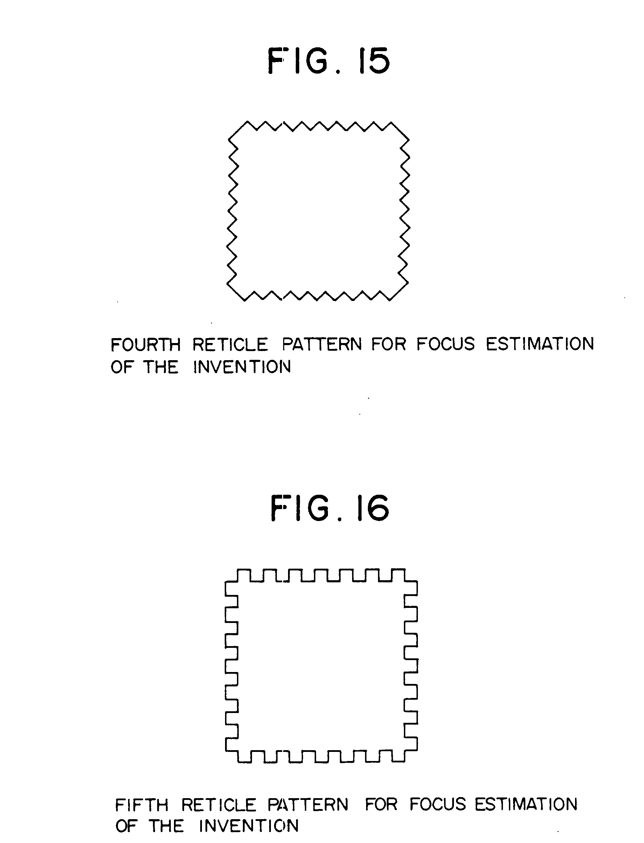

The shapes of serrate portions and comb tooth portions are changeable when the change is proper. Figs. 15, 16 show other examples. Fig. 15 is an example in which the shape of the serrate portions is formed as an isosceles triangle; Fig. 16 is an example in which the shape of the comb tooth portion is made as a square.

Although such serrate portions and comb tooth portions are effective even if formed only in either the X or the Y axial direction, the focus estimation in the X and Y axial directions can be done simultaneously from the same pattern if they are formed at the whole periphery of the pattern.

Industrial Applicability

According to the first invention, among patterns for focus estimation, a first pattern portion depicted on a body and depicted, when light is illuminated from a light source over the body, on a wafer below the body with a resoluble line width, and a second pattern portion, formed adjacent to the first pattern portion, having a very fine pattern depicted with a non-resoluble line width or isolated with a non-resoluble distance, are formed, so that, when the pattern is used, the conversion amount of the pattern size against the changes of the wafer position can be made larger.

According to the second invention, the best focus position can be easily judged because, at the process for transferring the pattern for focus estimation of the first invention onto the wafer, the pattern is transferred multiple times in varying distance between the pattern for focus estimation and the set position of the wafer; the distance from the end of the first transferred portion corresponding to the first pattern portion to the end of the second transferred portion corresponding to the second pattern portion, of the respective transferred patterns which are transferred onto the wafer by the multiple time transfers, is measured; the set position of the wafer at which the pattern comes into focus is judged from the measurement results.

Accordingly, from this judgment of the best focus position, the patterns can be accurately formed by finely adjusting the wafer position.

**Claims**

1. A method of determining the optimum position of a semiconductor wafer (175) with respect to a focal point thereof for use in an apparatus for manufacturing a semiconductor device, said apparatus having a radiation source (171), means (176) for supporting said wafer, and a reticle (173) interposed between said radiation source and said wafer, comprising the steps of:

   forming a reticle pattern (10, 40, 70) in the surface of said reticle (173), said reticle pattern having a plurality of elements (11, 52, 72) each separated from adjacent elements by a distance which is not greater than the resolution limit of the apparatus;
   changing in successive increments and/or decrements the distance between the wafer (175) and the reticle (173);
   projecting radiation from said radiation source (171) through said reticle pattern to form transferred reticle patterns on the wafer (175) at each of said incremental and/or decremental distances, each of said transferred reticle patterns having first and second spaced end portions;
   measuring the spacing between the first and second end portions of said transferred reticle patterns at each of said distances;
   selecting one of said measured spacings, namely the minimum or maximum value; and
   setting the wafer at the position corresponding to the selected spacing.

2. The method defined by claim 1 wherein said reticle pattern comprises a plurality of spaced parallel lines (11) of equal width.

3. The method defined by claim 2 wherein the spacing between each of said lines (11) is equal to the width of said lines.

4. The method defined in any of the preceeding claims wherein an image pattern is also formed on said reticle, said image pattern when projected on said wafer forming a projected image pattern on said wafer which is resolvable, the resolution of said projected image pattern being greater than the resolution limit of said apparatus.

5. The method defined by claim 1 wherein said reticle pattern comprises a rectangular area (41) having parallel spaced sides, opposite spaced sides of said rectangular area having triangular serrate portions (42).

6. The method defined by claim 5 wherein each of said triangular portions has a base which is twice the height thereof.

7. The method defined by claim 1 wherein said reticle pattern comprises a rectangular area (71) having parallel spaced sides, each of the sides of said rectangular area having plural rectangular comb-tooth shaped portions (72) wherein alternate first elements of said comb-tooth shaped portions have a first width, and second elements thereof located between each of said first elements have a second width.

8. The method defined by claim 7 wherein said second width being greater than said first width.

**Patentansprüche**

1. Verfahren zum Bestimmen der optimalen Position eines Halbleiterwafers (175) in bezug auf einen Brennpunkt davon zur Verwendung in einer Vorrichtung zum Herstellen einer Halbleitervorrichtung, wobei die Vorrichtung eine Strahlungsquelle (171), eine Einrichtung (176) zum Tragen des Wafers und ein Fadenkreuz (173), das zwischen der Strahlungsquelle und dem Wafer angeordnet ist, aufweist, welches Verfahren die folgenden Schritte aufweist:

Ausbilden eines Fadenkreuzmusters (10, 40, 70) in der Oberfläche des Fadenkreuzes (173), wobei das Fadenkreuzmuster eine Vielzahl von Elementen (11, 52, 72) hat, die jeweils um einen Abstand von benachbarten Elementen getrennt sind, der nicht größer als die Auflösungsgrenze der Vorrichtung ist;
Ändern des Abstands zwischen dem Wafer (175) und dem Fadenkreuz (173) in aufeinanderfolgenden Inkrementen und/oder Dekrementen;
Projizieren einer Strahlung von der Strahlungsquelle (171) durch das Fadenkreuzmuster, um übertragene Fadenkreuzmuster auf dem Wafer (175) bei jedem der inkrementellen und/oder dekrementellen Abstände auszubilden, wobei jedes der übertragenen Fadenkreuzmuster einen ersten und einen zweiten beabstandeten Endteil hat;
Messen der Beabstandung zwischen dem ersten und dem zweiten Endteil der übertragenen Fadenkreuzmuster bei jedem der Abstände;
Auswählen einer der gemessenen Beabstandungen, nämlich des minimalen oder des maximalen Werts; und
Einstellen des Wafers bei der Position entsprechend der gewählten Beabstandung.

2. Verfahren nach Anspruch 1, wobei das Fadenkreuzmuster eine Vielzahl von beabstandeten parallelen Linien (11) gleicher Breite aufweist.

3. Verfahren nach Anspruch 2, wobei die Beabstandung zwischen jeder der Linien (11) gleich der Breite der Linien ist.

4. Verfahren nach einem der vorangehenden Ansprüche, wobei ein Bildmuster auch auf dem Fadenkreuz ausgebildet wird, wobei das Bildmuster, wenn es auf den Wafer projiziert wird, ein projiziertes Bildmuster auf dem Wafer ausbildet, das auflösbar ist, wobei die Auflösung des projizierten Bildmusters größer als die Auflösungsgrenze der Vorrichtung ist.

5. Verfahren nach Anspruch 1, wobei das Fadenkreuzmuster einen rechteckigen Bereich (41) mit parallelen beabstandeten Seiten aufweist, wobei gegenüberliegende beabstandete Seiten des rechteckigen Bereichs dreieckige sägezahnförmige Teile (42) haben.

6. Verfahren nach Anspruch 5, wobei jeder der dreieckigen Teile eine Basis hat, die das Zweifache seiner Höhe ist.

7. Verfahren nach Anspruch 1, wobei das Fadenkreuzmuster einen rechteckigen Bereich (71) aufweist, der parallele beabstandete Seiten aufweist, wobei jede der Seiten des rechteckigen Bereichs mehrere rechteckige kammzahnförmige Teile (72) hat, wobei abwechselnde erste Elemente der kammzahnförmigen Teile eine erste Breite haben und ihre zweiten Elemente, die zwischen jedem der ersten Elemente angeordnet sind, eine zweite Breite haben.

8. Verfahren nach Anspruch 7, wobei die zweite Breite größer als die erste Breite ist.

**Revendications**

1. Procédé de détermination de la position optimale d'une plaquette (175) en semi-conducteur par rapport à son point focal pour utilisation dans un appareil de fabrication d'un dispositif à semi-conducteur, ledit appareil comportant une source (171) de rayonnement, un moyen (176) destiné à supporter ladite plaquette, et un réticule (173) interposé entre ladite source de rayonnement et ladite plaquette, comprenant les étapes, dans lesquelles :

   on forme un motif (10, 40, 70) de réticule dans la surface dudit réticule (173), ledit motif de réticule comportant plusieurs éléments (11, 52, 72) séparés chacun d'éléments adjacents par une distance qui n'est pas supérieure à la limite de définition de l'appareil ;
   on modifie par des incréments et/ou des décréments successifs la distance entre la plaquette (175) et le réticule (173) ;
   on projette un rayonnement de ladite source (171) de rayonnement à travers ledit motif de réticule pour former des motifs de réticule transférés sur la plaquette (175) à chacune desdites distances incrémentielle et/ou décrémentielle, chacun desdits motifs de réticule transférés comportant des première et seconde parties d'extrémité espacées ;
   on mesure l'écartement entre les première et seconde parties d'extrémité desdits motifs de réticule transférés à chacune desdites distances ;
   on choisit l'un desdits écartements mesurés, à savoir la valeur minimale ou maximale ; et
   on place la plaquette à la position correspondant à l'écartement choisi.

2. Procédé selon la revendication 1, dans lequel ledit motif de réticule comprend plusieurs lignes parallèles espacées de largeur égale (11).

3. Procédé selon la revendication 2, dans lequel l'écartement entre chacune desdites lignes (11) est égal à la largeur desdites lignes.

4. Procédé selon l'une quelconque des revendications précédentes, dans lequel un motif d'image est également formé sur ledit réticule, ledit motif d'image, lorsqu'il est projeté sur ladite plaquette, formant un motif d'image projeté sur ladite plaquette, lequel peut avoir une certaine définition, la définition dudit motif d'image projeté étant plus grande que la limite de définition dudit appareil.

5. Procédé selon la revendication 1, dans lequel ledit motif de réticule comprend une zone rectangulaire (41) ayant des côtés parallèles espacés, des côtés opposés espacés de ladite zone rectangulaire comportant des parties dentelées de manière triangulaire (42).

6. Procédé selon la revendication 5, dans lequel chacune desdites parties triangulaires comporte une base qui fait deux fois sa hauteur.

7. Procédé selon la revendication 1, dans lequel ledit motif de réticule comprend une zone rectangulaire (71) comportant des côtés parallèles espacés, chacun des côtés de ladite zone rectangulaire comportant plusieurs parties rectangulaires en forme de dents de peigne (72) dans lesquelles des premiers éléments alternés desdites parties en forme de dents de peigne ont une première largeur, et ses seconds éléments situés entre chacun desdits premiers éléments ont une seconde largeur.

8. Procédé selon la revendication 7, dans lequel ladite seconde largeur est supérieure à ladite première largeur.

# FIG. I

11 LINE PATTERN

10

(a ; WIDTH OF THE RESOLUTION LIMITATION OR BELOW)

aμm

FIRST RETICLE PATTERN FOR FOCUS ESTIMATION OF THE INVENTION

# FIG. 2

(a)

a = 0.35μm

(b)

a = 0.30μm

(c)

a = 0.25μm

(d)

a = 0.20μm

TRANSFERRED PATTERNS OF RETICLE PATTERN IN FIG. I

# FIG. 3

DIAGRAM ILLUSTRATING A RELATION BETWEEN WAFER
POSITION AND SIZE OF TRANSFERRED PATTERN
IN THE X-AXIAL DIRECTION

# FIG. 4

DIAGRAM ILLUSTRATING A RELATION BETWEEN WAFER
POSITION AND SIZE OF TRANSFERRED PATTERN

# FIG. 5

SECOND RETICLE PATTERN FOR FOCUS
ESTIMATION OF THE INVENTION

# FIG. 6

(a)

a = 0.35 μm

(b)

a = 0.30 μm

(c)

a = 0.25 μm

(d)

a = 0.20 μm

TRANSFERRED PATTERNS OF RETICLE PATTERN IN FIG.5

# FIG. 7

(a)

PART A

70

72

25μm

71

25μm

(b)

a1  a3

a2

THIRD RETICLE PATTERN FOR FOCUS ESTIMATION
OF THE INVENTION

FIG. 8

PATTERN(i)(a1=0.2, a3=0.3, a2=2.0 μm)

CONVERSION DIFFERENTIAL =0.81 μm

SIZE IN X-AXIAL DIRECTION [μm]

WAFER POSITION [μm]

# FIG. 9

PATTERN(ii) (a1 =0.2, a3 =0.3, a2 =3.0 $\mu$m )

EP 0 674 342 B1

# FIG. 10

PATTERN(iii) (al=0.2, a3=0.3, a2=5.0μm)

CONVERSION DIFFERENTIAL = 0.80μm

SIZE IN X-AXIAL DIRECTION [μm]

WAFER POSITION [μm]

EP 0 674 342 B1

# FIG. 11

PATTERN(iV) (a1=0.1, a3=0.2, a2=5.0 μm)

CONVERSION
DIFFERENTIAL = 0.70 μm

SIZE IN X-AXIAL DIRECTION [μm]

WAFER POSITION [μm]

EP 0 674 342 B1

FIG. 12

PATTERN(V)(a1=0.2, a3=0.2, a2=5.0 μm)

CONVERSION DIFFERENTIAL=0.34 μm

WAFER POSITION [μm]

SIZE IN X-AXIAL DIRECTION [μm]

# FIG. 13

PATTERN(Vi)(aI=0.1, a3=0.3, a2=5.0μm)

CONVERSION DIFFERENTIAL=0.31μm

SIZE IN X-AXIAL DIRECTION [μm]

WAFER POSITION [μm]

EP 0 674 342 B1

# FIG.14

EP 0 674 342 B1

# FIG. 15

FOURTH RETICLE PATTERN FOR FOCUS ESTIMATION OF THE INVENTION

# FIG. 16

FIFTH RETICLE PATTERN FOR FOCUS ESTIMATION OF THE INVENTION

# FIG.17

171 ILLUMINATION
OPTICAL SYSTEM

CONDENSOR LENS 172

RETICLE 173

REDUCTION LENS 174

WAFER 175

STAGE 176

STEPPER APPARATUS